# EUROPÄISCHE PATENTANMELDUNG

(11) **EP 4 247 131 A1**
(43) Veröffentlichungstag der Anmeldung: **20.09.2023**
(21) Anmeldenummer: 22161882.0
(22) Anmeldetag: 14.03.2022
(51) Int. Cl.: H05K 3/10, H05K 3/46, H05K 1/02, H05K 3/24, H05K 3/26, H05K 3/38, H05K 3/00

(54) **MIKROTECHNOLOGISCH HERGESTELLTE LEITERBAHNANORDNUNG UND HERSTELLVERFAHREN**

(71) Anmelder: Gottfried Wilhelm Leibniz Universität Hannover, 30167 Hannover (DE)
(72) Erfinder: Kassner, Alexander, 31185 Söhlde (DE); Wurz, Prof. Dr. Marc Christopher, 30629 Hannover (DE); Rasel, Prof. Dr. Ernst Maria, 30169 Hannover (DE); Herr, Dr. Waldemar, 30625 Hannover (DE); Heine, Hendrik, 30159 Hannover (DE)
(74) Vertreter: Kröncke, Rolf

(57) **Zusammenfassung**

Die Erfindung betrifft eine mikrotechnologisch hergestellte Leiterbahnanordnung, die wenigstens zwei elektrisch leitende Leiterbahnen aufweist. Die Erfindung betrifft außerdem ein Verfahren zur mikrotechnologischen Herstellung einer solchen Leiterbahnanordnung.

## Beschreibung

Die Erfindung betrifft eine mikrotechnologisch hergestellte Leiterbahnanordnung, die wenigstens zwei elektrisch leitende Leiterbahnen aufweist. Die Erfindung betrifft außerdem ein Verfahren zur mikrotechnologischen Herstellung einer solchen Leiterbahnanordnung.

Mikrotechnologisch hergestellte Leiterbahnanordnungen sind z.B. aus der US 10,319,896 B2 bekannt.

Der Erfindung liegt die Aufgabe zugrunde, mikrotechnologisch effizienter herstellbare Leiterbahnanordnungen und entsprechende Herstellverfahren anzugeben.

Diese Aufgabe wird gelöst durch eine mikrotechnologisch hergestellte Leiterbahnanordnung, die wenigstens zwei elektrisch leitende Leiterbahnen aufweist, die sich in Längsrichtung über wenigstens einen ersten Leiterbahnabschnitt erstrecken, wobei die wenigstens zwei Leiterbahnen in dem ersten Leiterbahnabschnitt sich wenigstens zweimal schneiden, entlang ihrer neutralen Faser eine stetigen Kurvenverlauf beschreiben und zueinander im Wesentlichen symmetrisch verlaufen. Die Erfindung hat den Vorteil, dass unter Verwendung von erprobten, zuverlässig durchführbaren mikrotechnologischen Prozessschritten eine Leiterbahnanordnung geschaffen werden kann, die im Sinne einer verdrillten Leitung (z.B. Twisted Pair) ausgebildet werden kann und hierdurch unempfindlich gegen die Einstreuung magnetischer und elektrischer Felder gemacht werden kann. Durch Verwendung erprobter mikrotechnologischer Prozessschritte kann eine solche Leiterbahnanordnung auch in großen Stückzahlen reproduzierbar hergestellt werden und ist Qualitätskontrollen zugänglich. Die Leiterbahnanordnung kann zudem relativ kostengünstig hergestellt werden.

Vorteilhafter Weise kann die Leiterbahnanordnung in der Ebene gefertigt werden, z.B. auf einer ebenen Oberfläche eines Substrats. Die mikrotechnologisch hergestellte Leiterbahnanordnung kann auf diese Weise als eine im Wesentlichen planare Anordnung ausgebildet sein. Die wenigstens zwei Leiterbahnen, die sich wenigstens zweimal schneiden, überschneiden sich dabei lediglich geometrisch in einer Draufsicht, berühren sich dabei aber nicht direkt, d.h. sie können gegeneinander isoliert sein. Beispielsweise können im Bereich eines Schnittpunkts die Leiterbahnen auf verschiedenen Höhenebenen angeordnet sein.

Als neutrale Faser wird dabei diejenige Faser oder Schicht einer Leiterbahn angesehen, dessen Länge sich bei einem theoretischen Verdrehen oder Verbiegen nicht ändert. Die neutrale Faser kann z.B. eine in Längsrichtung durch eine Leiterbahn verlaufende Mittellinie sein.

Die wenigstens zwei Leiterbahnen verlaufen zueinander im Wesentlichen symmetrisch, zumindest in einer bestimmten Betrachtungsrichtung. Beispielsweise können die Leiterbahnen in einer Draufsicht auf die Leiterbahnanordnung spiegelsymmetrisch zueinander verlaufen.

Die Begriffe "stetig", "Kurvenverlauf", "symmetrisch" und "Ebene" sind dabei im mathematischem Sinne zu verstehen.

Die einzelnen Leiterbahnen können grundsätzlich beliebige Formen haben, insbesondere beliebige Querschnittsformen. In einer vorteilhaften Ausgestaltung haben eine, mehrere oder alle Leiterbahnen eine überwiegend rechteckige Querschnittsform mit einer Leiterbahnbreite und einer Leiterbahndicke, die wesentlich geringer ist als die Leiterbahnbreite. Beispielsweise kann die Leiterbahndicke maximal 10 % der Leiterbahnbreite betragen.

Vorteilhafter Weise kann die Leiterbahnanordnung mikrotechnologisch hergestellt werden. Dabei können vorteilhafter Weise Prozessschritte der Mikrosystemtechnik und der Mikroverfahrenstechnik eingesetzt werden. Dabei ist es vorteilhaft, wenn die mikrotechnologisch hergestellte Leiterbahnanordnung ohne Kunststoff-basierte Herstellungsschritte hergestellt wird. Auf diese Weise können unerwünschte Ausgasungen vermieden werden.

Für die mikrotechnologische Herstellung der Leiterbahnanordnung können einer oder mehrere der nachfolgenden Prozessschritte, auch in Kombination miteinander, angewandt werden, um Schichten auf dem Substrat zu erzeugen:
- Gasphasen-Abscheidung, z.B. PVD, CVD;
- Aufdrucken, z.B. durch Siebdruck;
- Aufsprühen, z.B. durch Airbrush,
- Ätzen, z.B. Trockenätzprozesse wie z.B. das lonenstrahlätzen.

PVD steht für Physical Vapor Deposition, CVD für Chemical Vapor Deposition. Eine gewünschte Strukturierung einer Schicht kann während dieses Aufbringvorgangs erfolgen, z.B. durch Verwendung einer entsprechenden Maske.

Die Erfindung eignet sich insbesondere zur Herstellung von Mikrobauteilen und Mikrosystemen, d.h. elektrischen Schaltungsstrukturen in Mikrotechnologie. Als solche Mikrosysteme oder Mikrobauteile bezeichnet man Elemente, bei denen die einzelnen Strukturen, z.B. die Breite hergestellter Leiterbahnen, im Mikrometer-Bereich liegen, z.B. im Bereich von weniger als 500 µm.

Dementsprechend kann eine elektrische Schaltungsstruktur in Mikrotechnologie erzeugt werden. Hierbei kann die Materialdicke des Substrats beispielsweise wenigstens zehnmal so groß sein wie die Breite von auf dem Substrat erzeugten Leiterbahnen.

Die mikrotechnologisch hergestellte Leiterbahnanordnung hat, wie bereits die Vorsilbe "mikro" andeutet, Abmessungen im mikrotechnologischen Bereich, sodass sie für Einsatzzwecke in der Mikroelektronik geeignet ist. Beispielsweise kann die Leiterbahnbreite einer Leiterbahn <10 µm sein, die Leiterbahndicke kann <1 µm sein. Vorteilhaft ist z.B. eine Leiterbahndicke von etwa 300 nm. Die Dicke (Aufbauhöhe) des gesamten Aufbaus der Leiterbahnanordnung kann z.B. <3 µm sein, insbesondere <1 µm.

Die wenigstens zwei Leiterbahnen können sich in dem ersten Leiterbahnabschnitt insbesondere wesentlich häufiger als zweimal schneiden, beispielsweise mehr als zehnmal oder mehr als 20-mal. Die Länge des ersten Leiterbahnabschnitts kann beispielsweise wenigstens fünfmal oder wenigstens zehnmal so groß sein wie die Breite der Leiterbahnanordnung. Der Abstand zwischen benachbarten Schnittpunkten der Leiterbahnen, d.h. denjenigen Stellen, an denen sich die wenigstens zwei Leiterbahnen schneiden, kann dabei geringer sein als das Vierfache der Breite der Leiterbahnanordnung.

Gemäß einer vorteilhaften Ausgestaltung der Erfindung ist vorgesehen, dass die wenigstens zwei Leiterbahnen zumindest in dem ersten Leiterbahnabschnitt gegeneinander isoliert sind. Auf diese Weise können über die wenigstens zwei Leiterbahnen jeweils separate, voneinander unabhängige elektrische Signale übertragen werden. Beispielsweise können Signale eines Sensors, der an einem Ende der Leiterbahnanordnung daran angeschlossen ist, zu einem davon abgewandten Ende der Leiterbahnanordnung übertragen werden.

Gemäß einer vorteilhaften Ausgestaltung der Erfindung ist vorgesehen, dass die wenigstens zwei Leiterbahnen zumindest in dem ersten Leiterbahnabschnitt als verdrillte Leitungsanordnung ausgebildet sind. Auf diese Weise können sehr effizient Magnetfeldeinstreuungen und Einstreuungen elektrischer Felder in die Leiterbahnen verhindert werden. Auch ein Übersprechen zwischen benachbarten Leiterbahnanordnungen kann zuverlässig minimiert werden.

Gemäß einer vorteilhaften Ausgestaltung der Erfindung ist vorgesehen, dass der stetige Kurvenverlauf in einer Ebene ineinander übergehende Kreisfunktionsabschnitte und/oder ineinander übergehende Ellipsenfunktionsabschnitte aufweist. Auf diese Weise werden knickartige Richtungsänderungen des Verlaufs der Leiterbahnen vermieden, was den Vorteil hat, dass der Stromfluss durch die Leiterbahnen verbessert wird.

Gemäß einer vorteilhaften Ausgestaltung der Erfindung ist vorgesehen, dass die wenigstens zwei elektrisch leitenden Leiterbahnen zumindest in dem ersten Leiterbahnabschnitt auf einem Substrat angeordnet sind, das eine größere Dicke hat als die Anordnung der wenigstens zwei Leiterbahnen in dem ersten Leiterbahnabschnitt. Das Substrat kann somit einen relativ massiven Träger für die Leiterbahnanordnung bilden. Prinzipiell kann hierfür jedes beliebige Substrat verwendet werden. Vorteilhaft sind beispielsweise Substrate aus Silizium, Glas oder Keramik.

Als Material für die Leiterbahnen kann grundsätzlich jedes elektrisch leitfähige Material verwendet werden, insbesondere Metalle. Besonders vorteilhaft ist die Verwendung nicht-magnetischer Metalle wie z.B. Platin. Im Falle einer Supraleitung können die Leiterbahnen auch auf Keramikbasis hergestellt werden.

Gemäß einer vorteilhaften Ausgestaltung der Erfindung ist vorgesehen, dass die wenigstens zwei Leiterbahnen zumindest in den Bereichen, in denen sie sich schneiden, unterschiedliche Abstände zu dem Substrat aufweisen. Dementsprechend werden bestimmte Leiterbahnabschnitte in unterschiedlichen Ebenen auf dem Substrat gefertigt. Auf diese Weise kann eine verdrillte Leitungsanordnung ohne unerwünschte elektrische Kontaktierung zwischen den Leiterbahnen untereinander geschaffen werden. Vorteilhafterweise kann zumindest in den Bereichen, in denen sich die wenigstens zwei Leiterbahnen schneiden, Isolationsmaterial zwischen den wenigstens zwei Leiterbahnen angeordnet sein.

Gemäß einer vorteilhaften Ausgestaltung der Erfindung ist vorgesehen, dass die wenigstens zwei Leiterbahnen zwischen zwei benachbarten Schnittpunkten um wenigstens 20% der Leiterbahnbreite voneinander beabstandet sind. Auf diese Weise ist zwischen den zwei Leiterbahnen in einem Bereich zwischen zwei benachbarten Schnittpunkten ein vergleichsweise großer Freiraum gebildet. Der Freiraum kann z.B. in Draufsicht auf die Leiterbahnanordnung die geometrische Form einer Ellipse haben, die im Bereich der Schnittpunkte der Leiterbahnabschnitte eckigen Endabschnitte hat.

Die Erfindung betrifft außerdem einen Atom-Chip für eine Atom-optische Vorrichtung, aufweisend einen Grundkörper und wenigstens einen Sensor zur Sensierung einer physikalischen Größe auf dem Atom-Chip, wobei der Sensor an eine mikrotechnologisch hergestellte Leiterbahnanordnung mit wenigstens zwei elektrisch leitenden Leiterbahnen angeschlossen ist, die auf dem Grundkörper angeordnet ist, wobei der Sensor über die mikrotechnologisch hergestellte Leiterbahnanordnung mit einer Auswerteschaltung zur Auswertung der Signale des Sensors verbindbar ist. Dies hat den Vorteil, dass die Signale des Sensors weitgehend störungsfrei an eine Auswerteschaltung übertragen werden können. Der Sensor erlaubt es, wenigstens eine physikalische Größe auf dem Atom-Chip zu erfassen, beispielsweise eine Temperatur. Die Atom-optische Vorrichtung kann z.B. eine magneto-optische Falle sein oder diese aufweisen. Der Atom-Chip kann z.B. für einen Quantencomputer oder ein Gravimeter eingesetzt werden.

Ein Atom-Chip wird vornehmlich in der Atom-Optik eingesetzt. Er dient dort dazu Atome und Atomwolken in miniaturisierten Magnetfallen zu speichern und zu manipulieren. Atom-Chips entspringen dem Wunsch, starke Magnetfeldgradienten und komplexe magnetische Potentiale mit überschaubarem Aufwand zu generieren. Auch Systeme zur Detektion der Atome, wie zum Beispiel Resonatoren oder optische Fasern, können direkt auf dem Atom-Chip integriert werden. Die grundlegende Idee eines Atom-Chips ist es, dass sich durch elektrische Leiterbahnen in unmittelbarer Nähe der Atomwolke schon mit geringen Stromstärken hohe Magnetfelder und magnetische Feldgradienten erzeugen lassen, die es erlauben Atome kontrolliert zu fangen.

Gemäß einer vorteilhaften Ausgestaltung der Erfindung ist vorgesehen, dass die mikrotechnologisch hergestellte Leiterbahnanordnung, die auf dem Grundkörper angeordnet ist, zumindest in einem ersten Leiterbahnabschnitt als verdrillte Leitungsanordnung ausgebildet ist. Dies hat den Vorteil, dass mit dem Sensor auch kleine Signale zuverlässig erfasst werden können. Durch die verdrillte Leitungsanordnung können unerwünschte Einstreuungen magnetischer und elektrischer Felder weitgehend vermieden werden. Dementsprechend kann die Signalerfassung der Sensorsignale verbessert werden.

Die eingangs genannte Aufgabe wird außerdem gelöst durch ein Verfahren zur mikrotechnologischen Herstellung einer Leiterbahnanordnung, die wenigstens zwei elektrisch leitende Leiterbahnen aufweist, die sich in Längsrichtung über wenigstens einen ersten Leiterbahnabschnitt erstrecken, wobei die wenigstens zwei Leiterbahnen in dem ersten Leiterbahnenabschnitt sich wenigstens zweimal schneiden, entlang ihrer neutralen Faser eine stetigen Kurvenverlauf beschreiben und zueinander im Wesentlichen symmetrisch verlaufen, insbesondere Verfahren zur Herstellung einer mikrotechnologisch hergestellten Leiterbahnanordnung nach einem der vorhergehenden Ansprüche, mit den Schritten:
a) mikrotechnologisches Erzeugen von voneinander getrennten ersten Längsabschnitten der Leiterbahnen in einer ersten Schicht auf dem Substrat,
b) mikrotechnologisches Erzeugen von voneinander getrennten zweiten Längsabschnitten der Leiterbahnen in einer zweiten Schicht auf dem Substrat, wobei die zweite Schicht vom Substrat aus gesehen oberhalb der ersten Schicht angeordnet ist und ein jeweiliger zweiter Längsabschnitt jeweils zwei erste Längsabschnitte einer Leiterbahn miteinander elektrisch verbindet, derart, dass eine durchgehende Leiterbahn aus abwechselnd aneinander gesetzten ersten und zweiten Längsabschnitten gebildet wird.

Auch hierdurch können die zuvor erläuterten Vorteile realisiert werden. Die erste Schicht und/oder die zweite Schicht auf dem Substrat kann z.B. eine im Wesentlichen ebene Schicht sein. Vor dem Aufbringen der ersten Längsabschnitte in der ersten Schicht kann auf dem Substrat z.B. eine Haftvermittlerschicht aufgebracht worden sein, z.B. eine Schicht aus Chrom, Titan oder Tantal.

An den Stellen, an denen sich die wenigstens zwei Leiterbahnen schneiden, überschneidet sich ein erster Längsabschnitt der einen Leiterbahn mit einem zweiten Längsabschnitt einer anderen Leiterbahn.

Gemäß einer vorteilhaften Ausgestaltung der Erfindung ist vorgesehen, dass die ersten Längsabschnitte und/oder die zweiten Längsabschnitte als kurvenförmige Abschnitte mit einer vorgegebenen Krümmung hergestellt werden. Auf diese Weise kann ein stetiger Kurvenverlauf der Leiterbahnen ohne Ecken bereitgestellt werden. Dies ist vorteilhaft für den Stromfluss durch die Leiterbahn.

Gemäß einer vorteilhaften Ausgestaltung der Erfindung ist vorgesehen, dass nach dem Schritt a) die ersten Längsabschnitte zumindest in den Bereichen, in denen sie sich mit den zweiten Längsabschnitten überschneiden sollen, mit einer mikrotechnologisch erzeugten Isolationsschicht überdeckt werden. Auf diese Weise werden unerwünschte galvanische Verbindungen zwischen den gegeneinander isolierten Leiterbahnen an den Schnittpunkten vermieden.

Dies kann derart erfolgen, dass die Isolationsschicht nur an den gewünschten Stellen erzeugt wird, sodass bestimmte Teile der ersten Längsabschnitte nicht mit der Isolationsschicht überdeckt werden und somit direkt elektrisch mit einem zweiten Längsabschnitt verbunden werden können. Es ist auch möglich, dass die ersten Längsabschnitte vollständig oder überwiegend mit der Isolationsschicht überdeckt werden und in einem nachfolgenden Schritt mittels eines mikrotechnologischen Prozesses die Isolationsschicht zumindest in den Bereichen wieder entfernt wird, in denen ein erster Längsabschnitt mit einem zweiten Längsabschnitt elektrisch verbunden werden soll.

Vor dem Aufbringen der Isolationsschicht kann ein Auftrag einer weiteren Haftvermittlerschicht auf der Oberseite der Anordnung erfolgen. Diese sorgt dafür, dass die Isolationsschicht gut mit den darunterliegenden Schichten verbunden wird.

Die Erfindung wird nachfolgend anhand von Ausführungsbeispielen unter Verwendung von Zeichnungen näher erläutert.

Es zeigen
- Figuren 1 bis 5: Herstellungsschritte einer Leiterbahnanordnung auf einem Substrat,
- Figur 6: einen Abschnitt einer Leiterbahnanordnung mit einem Sensor in Draufsicht,
- Figur 7: einen Atom-Chip in Draufsicht.

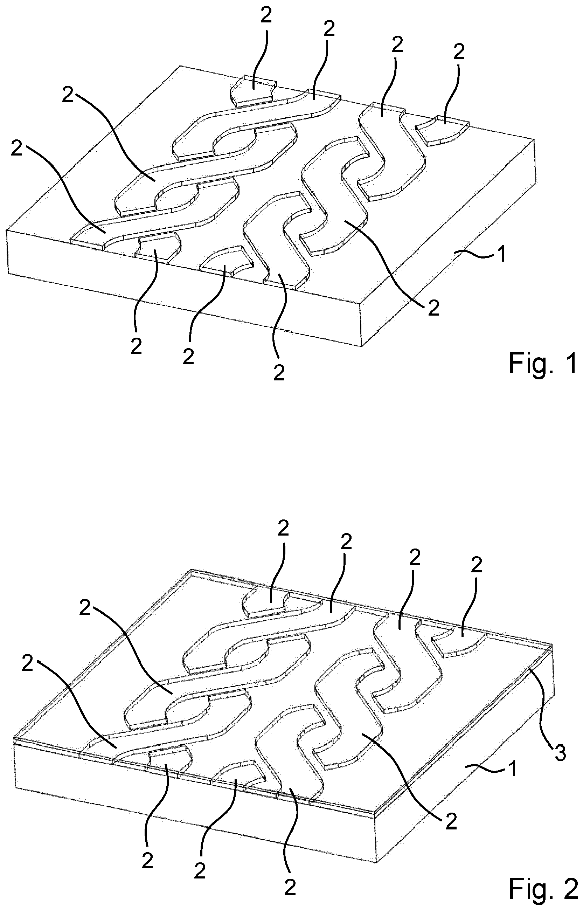

In der Figur 1 ist erkennbar, dass auf einem Substrat 1 durch mikrotechnologische Herstellungsschritte mehrere erste Längsabschnitte 2 von Leiterbahnen erzeugt worden sind. Im dargestellten Ausführungsbeispiel sollen zwei nebeneinander liegende, parallel zueinander verlaufende Leiterbahnanordnungen hergestellt werden, die jeweils zwei elektrisch leitende Leiterbahnen haben. Insgesamt sollen somit vier Leiterbahnen erzeugt werden. Jeweils zwei Leiterbahnen einer Leiterbahnanordnung sollen als verdrilltes Paar von Leitungen erzeugt werden.

Die Figur 2 zeigt, dass auf die Anordnung gemäß Figur 1 eine Isolationsschicht 3 aufgebracht wurde.

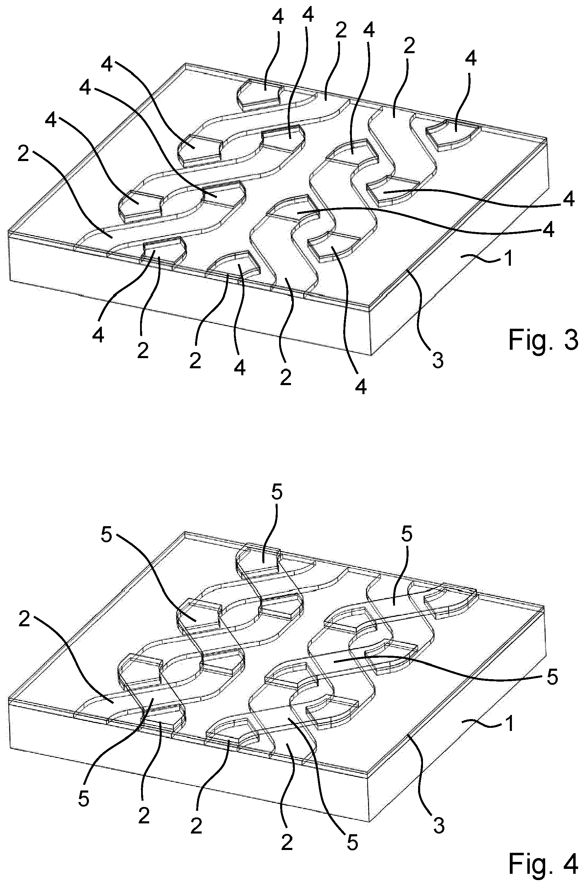

Da die Isolationsschicht 3 vollflächig aufgebracht wurde, werden danach, wie die Figur 3 verdeutlicht, jeweils an den Enden der ersten Längsabschnitte 2 Bereiche 4 wieder freigelegt, d.h. von der Isolationsschicht befreit. Hiernach kann wiederum eine Haftvermittlerschicht auf die Oberfläche aufgebracht werden.

Wie die Figur 4 zeigt, sind nun jeweils voneinander getrennte zweite Längsabschnitte 5 der Leiterbahnen in einer zweiten Schicht auf dem Substrat 1 erzeugt. Ein jeweiliger zweiter Längsabschnitt 5 verbindet zwei unmittelbar benachbarte erste Längsabschnitte 2. Die ersten Längsabschnitte 2 werden an den vom Isolationsmaterial freigelegten Bereichen 4 von den zweiten Längsabschnitten 5 galvanisch kontaktiert. Auf diese Weise sind miteinander verdrillte Leiterbahn-Paare hergestellt.

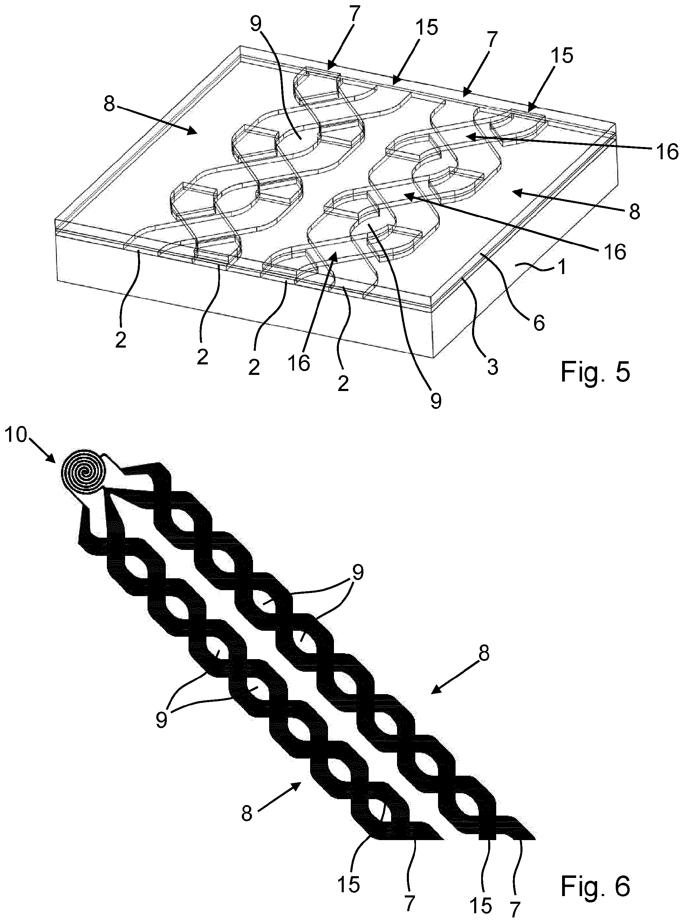

Da sich die zweiten Längsabschnitte 5 in einer höher gelegenen Ebene befinden als die ersten Längsabschnitte 2, kann es vorteilhaft sein, die Oberfläche des entstandenen Gesamtsystems wieder planar zu gestalten. Dies kann z.B., wie die Figur 5 zeigt, durch das Aufbringen einer weiteren elektrischen Isolationsschicht 6 erfolgen, z.B. durch Aufbringen einer Spin-on-Glass-Schicht. Die Isolationsschicht 6 kann z.B. eine Dicke bis zu 1 µm haben.

Man erkennt in der Figur 5, dass nun zwei mikrotechnologisch hergestellte Leiterbahnanordnungen 8 auf dem Substrat 1 erzeugt sind. Jede Leiterbahnanordnung 8 weist eine erste Leiterbahn 7 und eine zweite Leiterbahn 15 auf. Die Leiterbahnen 7, 15 sind als verdrilltes Leiterbahn-Paar angeordnet. Zwischen den jeweiligen Schnittpunkten 16 der Leiterbahnen 7, 15 sind diese voneinander beabstandet, d. h. sie liegen nicht eng aneinander an, sodass ein Zwischenraum 9 gebildet ist, der in Draufsicht im Wesentlichen elliptisch mit zu den Schnittpunkten 16 hin gewandten Ecken gebildet ist.

Die Figur 6 zeigt einen längeren Längsabschnitt der zwei Leiterbahnanordnungen 8 mit den verdrillten Leiterbahnen 7, 15. An einem Ende der Leiterbahnanordnungen 8 ist ein Sensor 10 angeschlossen, z.B. der zuvor erwähnte Sensor, der ebenfalls im Laufe der mikrotechnologischen Herstellschritte mit erzeugt werden kann.

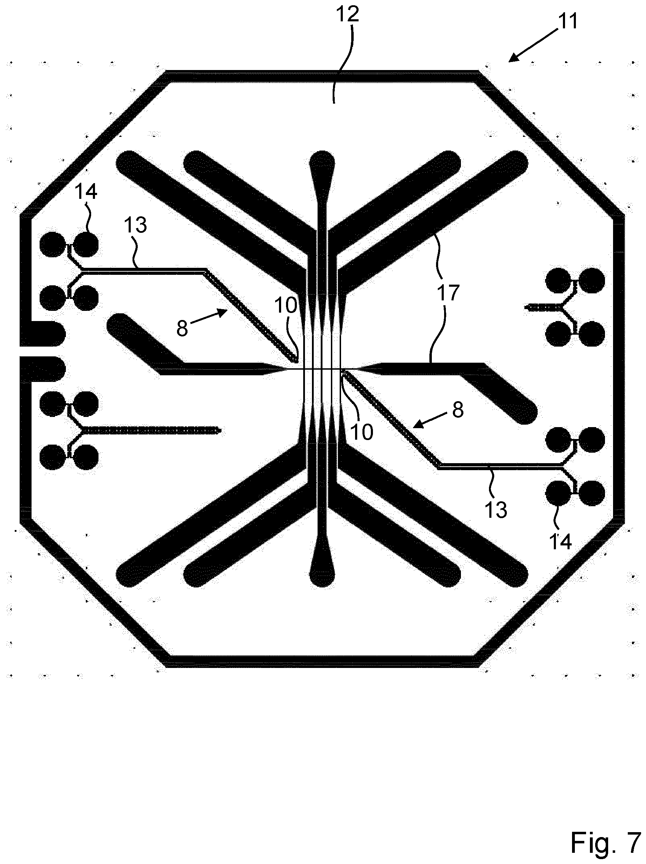

Die Figur 7 zeigt einen Atom-Chip 11 mit einem Grundkörper 12, auf dem mehrere der anhand der Figur 6 erläuterten Sensor-Leiterbahn-Anordnungen vorhanden sind. Erkennbar sind jeweilige Sensoren 10, die über die Leiterbahnanordnungen 8, d.h. die verdrillten Leitungen, mit weiterführenden Leitungen 13 verbunden sind, die z.B. als normale Leiterbahnen ohne Verdrillung ausgebildet sein können. Die Leiterbahnen 13 enden an Anschlussflächen 14, z.B. Bondpads oder Lötpads, an denen beispielsweise eine Auswerteschaltung zur Auswertung der Signale der Sensoren 10 angeschlossen werden kann.

Beispielsweise kann ein Herstellungs-Ablauf wie folgt aussehen. Hierzu werden zunächst die ersten Längsabschnitte 2 der Leiterbahnen 7, 15 der verdrillten Zuleitung und der Sensor 10 generiert. Hierbei kann prinzipiell jedes beliebige Substrat 1 verwendet werden; Voraussetzung ist die mikrotechnologische Bearbeitbarkeit, z.B. Silizium, Glas, ggf. Keramik. Es folgt die Generierung einer Haftvermittlerschicht aus Chrom auf der Oberfläche des Substrats 1. Titan oder Tantal würden ebenfalls als Haftvermittlungswerkstoff in Betracht kommen. Anschließend werden die ersten Längsabschnitte 2 der Leiterbahnen 7, 15 generiert, die aus einem elektrisch leitfähigen nicht-magnetischen Metall hergestellt werden kann, z.B. Platin. Auch eine Supraleitung auf Keramikbasis erscheint realisierbar. Da die ersten Längsabschnitte 2 der Leiterbahnen 7, 15 in einem Schritt mit dem Sensor erzeugt werden lönnen, ist es sinnvoll, dasselbe Material zu verwenden, das auch für den Sensor verwendet werden soll, für Temperatursensoren z.B. Platin.

Es folgt der Auftrag einer weiteren Haftvermittlerschicht auf der Oberseite. Diese sorgt dafür, dass die Isolierung auf den ersten Längsabschnitten 2 der Leiterbahnen 7, 15 sowie ggf. der Sensor 10 mechanisch verbunden wird. Anschließend kann der Atom-Chip 11 gefertigt werden. Hierzu kann eine Fotomaske aufgebracht werden. Die für den Atom-Chip 11 erforderlichen Kavitäten und die Kavitäten für die später zu generierenden Leiterbahnen verwendet werden geätzt. (Ätztiefe beträgt z.B. 10µm bis 20µm). Für das hier verwendete Siliziumsubstrat kann hierzu ein lonentiefätzprozess verwendet werden, um einen rechteckigen Leiterbahnquerschnitt realisieren zu können. Alternativ eignen sich auch Trockenätzprozesse wie z.B. das lonenstrahlätzen. Die Ätztiefe beträgt 10µm bis 20µm, je nachdem, wieviel Strom fließen soll. Im nächsten Schritt werden die Durchführungen für die elektrische Durchkontaktierung gefertigt. Dafür wird wieder eine Fotomaske aufgebracht und anschließend per Ätzung die notwendige Kavität vorgesehen. Anschließend kann das gesamte System elektrisch isoliert werden, z.B. durch Aufbringen der Isolationsschicht 3.

Wie bereits erwähnt, können nunmehr die generierten Kavitäten mit Leitermaterial befüllt werden. Hierzu wird zunächst eine Haftvermittlerschicht, gefolgt von einer elektrisch leitfähigen Startschicht per PVD Verfahren appliziert.

Es folgt die Aufbringung einer Fotomaske zum Zwecke der Abschirmung des Atom-chips, um durch galvanische Abscheidung die Kavitäten für einzubringende Leiterbahnen zu generieren, die dann per galvanischen Abscheidung von Gold in den Kavitäten als Leiterbahnen eingebracht werden.

Diese elektrischen Leiterbahnen können bei Bedarf komplett verfüllt werden. Dies ist jedoch keine zwingende Voraussetzung, da auch eine Beschichtung auf den Seitenwänden ausreicht, um eine Kontaktierung zur Rückseite des Substrats zu führen. Die rückseitige Kontaktierung ist vorteilhaft, um den optischen Zugang zum Atom-Chip zu gewährleisten. Anschließend wird die Startschicht mittels Ionenstrahlätzen (IBE) entfernt, sowie das gesamte System mittels CMP (chemisch mechanisches Polieren) planarisiert. Es folgt die Fertigung der zweiten Längsabschnitte 5 der Leiterbahnen 7, 15 der verdrillten Zuleitung. Zunächst muss hierfür die ganzflächige Isolationsschicht "partiell geöffnet" werden. Dafür wird eine Fotomaske aufgebracht und die Isolationsschicht anschließend weggeätzt.

Dadurch entstehen im Bereich der Verdrillung, d.h. an den Schnittpunkten 16 , Isolationsdurchführungen, sodass mit dem nachfolgenden PVD Schritt die Verbindungsbrücken (=obere Leiterbahn) hergestellt werden konnten. Dies erfolgt nach demselben Schema, wie der mikroproduktionstechnische Herstellungsablauf der unteren Leiterbahnen, d.h. mit einer Haftvermittlerschicht auf der Oberseite. Auf der Unterseite ist das Vorsehen einer solchen Haftvermittlerschicht nicht erforderlich, da hier bereits die Haftvermittlerschicht auf der unteren Leiterbahn vorhanden war.

Da nunmehr die obere Leiterbahn, d.h. die zweiten Längsabschnitte 5 der Leiterbahnen 7, 15, "übersteht", kann die Oberfläche des Systems erneut planarisiert werden. Dafür kann eine dünne Schicht Spin-on-Glass aufgebracht werden (bis 1µm Dicke), die einerseits eine elektrische Isolationsschicht "nach oben" darstellt und andererseits Höhenunterschiede in gewissem Grad ausgleicht. Abschließend erfolgt ein CMP Schritt zur endgültigen Planarisierung. Zuletzt wird eine Funktionsschicht per Abscheidung aufgebracht.

Durch Ausführung der Leitersegmente in Mäanderform, bei dem zwischen den Leiterbahnen ein annähernd ellipsenförmiger Zwischenraum 9 erhalten bleibt (Fig. 5, 6), kann eine Optimierung der Homogenität der Stromdichte festgestellt werden, was vorteilhaft zur gegenseitigen Aufhebung induzierter, magnetischer sowie elektrischer Felder ist. Im Gegensatz zum Stand der Technik ist es möglich, die für einen Quantenrechner essentiell notwendige nahtlose, feldneutrale Sensorkontaktierung mikroproduktionstechnisch in der Ebene zu gewährleisten. Zum einen kann hierdurch vergleichsweise kostengünstig ein Feldisolationsleiter hergestellt werden, zum anderen kann dieser Feldisolationsleiter an beliebige Sensormodule angeschlossen werden.

## Patentansprüche

1. Mikrotechnologisch hergestellte Leiterbahnanordnung (8), die wenigstens zwei elektrisch leitende Leiterbahnen (7, 15) aufweist, die sich in Längsrichtung über wenigstens einen ersten Leiterbahnabschnitt erstrecken, wobei die wenigstens zwei Leiterbahnen (7, 15) in dem ersten Leiterbahnabschnitt sich wenigstens zweimal schneiden, entlang ihrer neutralen Faser eine stetigen Kurvenverlauf beschreiben und zueinander im Wesentlichen symmetrisch verlaufen.

2. Mikrotechnologisch hergestellte Leiterbahnanordnung nach Anspruch 1,
**dadurch gekennzeichnet, dass** die wenigstens zwei Leiterbahnen (7, 15) zumindest in dem ersten Leiterbahnabschnitt gegeneinander isoliert sind.

3. Mikrotechnologisch hergestellte Leiterbahnanordnung nach einem der vorhergehenden Ansprüche, **dadurch gekennzeichnet, dass** die wenigstens zwei Leiterbahnen (7, 15) zumindest in dem ersten Leiterbahnabschnitt als verdrillte Leitungsanordnung ausgebildet sind.

4. Mikrotechnologisch hergestellte Leiterbahnanordnung nach einem der vorhergehenden Ansprüche, **dadurch gekennzeichnet, dass** der stetige Kurvenverlauf in einer Ebene ineinander übergehende Kreisfunktionsabschnitte und/oder ineinander übergehende Ellipsenfunktionsabschnitte aufweist.

5. Mikrotechnologisch hergestellte Leiterbahnanordnung nach einem vorhergehenden Ansprüche, **dadurch gekennzeichnet, dass** die wenigstens zwei elektrisch leitenden Leiterbahnen (7, 15) zumindest in dem ersten Leiterbahnabschnitt auf einem Substrat (1) angeordnet sind, das eine größere Dicke hat als die Anordnung der wenigstens zwei Leiterbahnen (7, 15) in dem ersten Leiterbahnabschnitt.

6. Mikrotechnologisch hergestellte Leiterbahnanordnung nach Anspruch 5,
**dadurch gekennzeichnet, dass** die wenigstens zwei Leiterbahnen (7, 15) zumindest in den Bereichen, in denen sie sich schneiden, unterschiedliche Abstände zu dem Substrat (1) aufweisen.

7. Mikrotechnologisch hergestellte Leiterbahnanordnung nach einem der vorhergehenden Ansprüche, **dadurch gekennzeichnet, dass** zumindest in den Bereichen, in denen sich die wenigstens zwei Leiterbahnen (7, 15) schneiden, Isolationsmaterial zwischen den wenigstens zwei Leiterbahnen (7, 15) angeordnet ist.

8. Mikrotechnologisch hergestellte Leiterbahnanordnung nach einem der vorhergehenden Ansprüche, **dadurch gekennzeichnet, dass** die wenigstens zwei Leiterbahnen (7, 15) zwischen zwei benachbarten Schnittpunkten (16) um wenigstens 20% der Leiterbahnbreite voneinander beabstandet sind.

9. Atom-Chip (11) für eine Atom-optische Vorrichtung, aufweisend einen Grundkörper (12) und wenigstens einen Sensor (10) zur Sensierung einer physikalischen Größe auf dem Atom-Chip (11), wobei der Sensor (10) an eine mikrotechnologisch hergestellte Leiterbahnanordnung (8) mit wenigstens zwei elektrisch leitenden Leiterbahnen (7, 15) angeschlossen ist, die auf dem Grundkörper (12) angeordnet ist, wobei der Sensor (10) über die mikrotechnologisch hergestellte Leiterbahnanordnung (8) mit einer Auswerteschaltung zur Auswertung der Signale des Sensors (10) verbindbar ist.

10. Atom-Chip nach Anspruch 9, **dadurch gekennzeichnet, dass** die mikrotechnologisch hergestellte Leiterbahnanordnung (8), die auf dem Grundkörper (12) angeordnet ist, zumindest in einem ersten Leiterbahnabschnitt als verdrillte Leitungsanordnung ausgebildet ist.

11. Verfahren zur mikrotechnologischen Herstellung einer Leiterbahnanordnung (8), die wenigstens zwei elektrisch leitende Leiterbahnen (7, 15) aufweist, die sich in Längsrichtung über wenigstens einen ersten Leiterbahnabschnitt erstrecken, wobei die wenigstens zwei Leiterbahnen (7, 15) in dem ersten Leiterbahnenabschnitt sich wenigstens zweimal schneiden, entlang ihrer neutralen Faser eine stetigen Kurvenverlauf beschreiben und zueinander im Wesentlichen symmetrisch verlaufen, insbesondere Verfahren zur Herstellung einer mikrotechnologisch hergestellten Leiterbahnanordnung (8) nach einem der vorhergehenden Ansprüche, mit den Schritten:
a) mikrotechnologisches Erzeugen von voneinander getrennten ersten Längsabschnitten (2) der Leiterbahnen (7, 15) in einer ersten Schicht auf dem Substrat (1),
b) mikrotechnologisches Erzeugen von voneinander getrennten zweiten Längsabschnitten (5) der Leiterbahnen (7, 15) in einer zweiten Schicht auf dem Substrat (1), wobei die zweite Schicht vom Substrat (1) aus gesehen oberhalb der ersten Schicht angeordnet ist und ein jeweiliger zweiter Längsabschnitt (5) jeweils zwei erste Längsabschnitte (2) einer Leiterbahn (7, 15) miteinander elektrisch verbindet, derart, dass eine durchgehende Leiterbahn aus abwechselnd aneinander gesetzten ersten und zweiten Längsabschnitten (2, 5) gebildet wird.

12. Verfahren nach Anspruch 11, **dadurch gekennzeichnet, dass** die ersten Längsabschnitte (2) und/oder die zweiten Längsabschnitte (5) als kurvenförmige Abschnitte mit einer vorgegebenen Krümmung hergestellt werden.

13. Verfahren nach einem der Ansprüche 11 bis 12, **dadurch gekennzeichnet, dass** nach dem Schritt a) die ersten Längsabschnitte (2) zumindest in den Bereichen, in denen sie sich mit den zweiten Längsabschnitten (5) überschneiden sollen, mit einer mikrotechnologisch erzeugten Isolationsschicht (3) überdeckt werden.
